Europäisches Patentamt

European Patent Office

Office européen des brevets

(11) Veröffentlichungsnummer: **0 054 626**
B1

(12) # EUROPÄISCHE PATENTSCHRIFT

(45) Veröffentlichungstag der Patentschrift:
20.03.85

(51) Int. Cl.⁴: **G 01 R 33/06**, G 01 R 15/02

(21) Anmeldenummer: **81107420.2**

(22) Anmeldetag: **18.09.81**

(54) **Magnetoresistiver Stromdetektor.**

(30) Priorität: **24.12.80 CH 9567/80**

(43) Veröffentlichungstag der Anmeldung:
**30.06.82 Patentblatt 82/26**

(45) Bekanntmachung des Hinweises auf die Patenterteilung:
**20.03.85 Patentblatt 85/12**

(84) Benannte Vertragsstaaten:
**AT DE FR GB IT NL**

(56) Entgegenhaltungen:
**EP - A - 0 030 041**
**US - A - 3 546 579**
**US - A - 3 555 310**
**US - A - 3 649 912**
**US - A - 3 820 089**

**IEEE TRANSACTIONS ON MAGNETICS, Band MAG-12, Nr. 6, November 1976, New York (US) C.H. BAJOREK et al.: "A permalloy current sensor" Seiten 813-815**

(73) Patentinhaber: **LGZ LANDIS & GYR ZUG AG,**
**CH-6301 Zug (CH)**

(72) Erfinder: **Lienhard, Heinz, Dipl.-Ing., Neufrauenstein 12,**
**CH-6300 Zug (CH)**
Erfinder: **Petr, Jan, Dipl.-Ing., Stolzengrabenstrasse 33,**
**CH-6317 Oberwil (CH)**
Erfinder: **Steinle, Benedikt, Dr., Schönbühl 10,**
**CH-6300 Zug (CH)**

(74) Vertreter: **Müller, Hans-Jürgen, Dipl.-Ing., Müller,**
**Schupfner & Gauger**
**Lucile-Grahn-Strasse 38 Postfach 80 13 69,**
**D-8000 München 80 (DE)**

## Beschreibung

Es ist ein Stromdetektor der im Oberbegriff des Anspruchs 1 genannten Art bekannt (IEEE Transactions on Magnetics, Vol. MAG-12, No. 6, Nov. 1976, Seiten 813–815), bei dem jedes der vier Brückenelemente aus einem Paar magnetoresistiver Dünnfilme besteht, die magnetostatisch miteinander gekoppelt sind. Die beiden Dünnfilme eines Dünnfilmpaares sind unterschiedlich dick gewählt, damit sich die gegenläufigen Widerstandsänderungen der beiden Dünnfilme nicht gegenseitig aufheben und ein befriedigend grosses Ausgangssignal entsteht.

Der im Anspruch 1 angegebenen Erfindung liegt die Aufgabe zugrunde, einen Stromdetektor der genannten Art dahingehend zu verbessern, dass er sich durch einen einfacheren Aufbau und eine bessere Linearität auszeichnet.

Weiterbildungen der Erfindung sind in den Ansprüchen 2 bis 5 angegeben.

In der EP-A-0 030 041 (Priorität: 27.11.79, Veröffentlichungstag: 10.06.81, benannte Vertragsstaaten: DE, FR, GB, IT, NL, SE) ist zudem ein Messwandler zum Messen eines insbesondere von einem Messstrom erzeugten Magnetfeldes vorgeschlagen worden, der die im Oberbegriff des vorliegenden Anspruchs 1 enthaltenen Merkmale aufweist und bei dem zusätzlich beide Dünnfilme jedes Dünnfilmpaares gleich dick ausgebildet und elektrisch voneinander isoliert sind.

Nachfolgend wird ein Ausführungsbeispiel der Erfindung anhand der Zeichnung näher erläutert.

Es zeigen:

Figur 1 Teile eines Stromdetektors in perspektivischer Darstellung,
Figur 2 ein Schaltbild einer Brücke,
Figur 3 ein Prinzipschaltbild eines Stromdetektors,
Figur 4 eine Variante,
Figur 5 eine weitere Variante und
Figur 6 ein Diagramm.

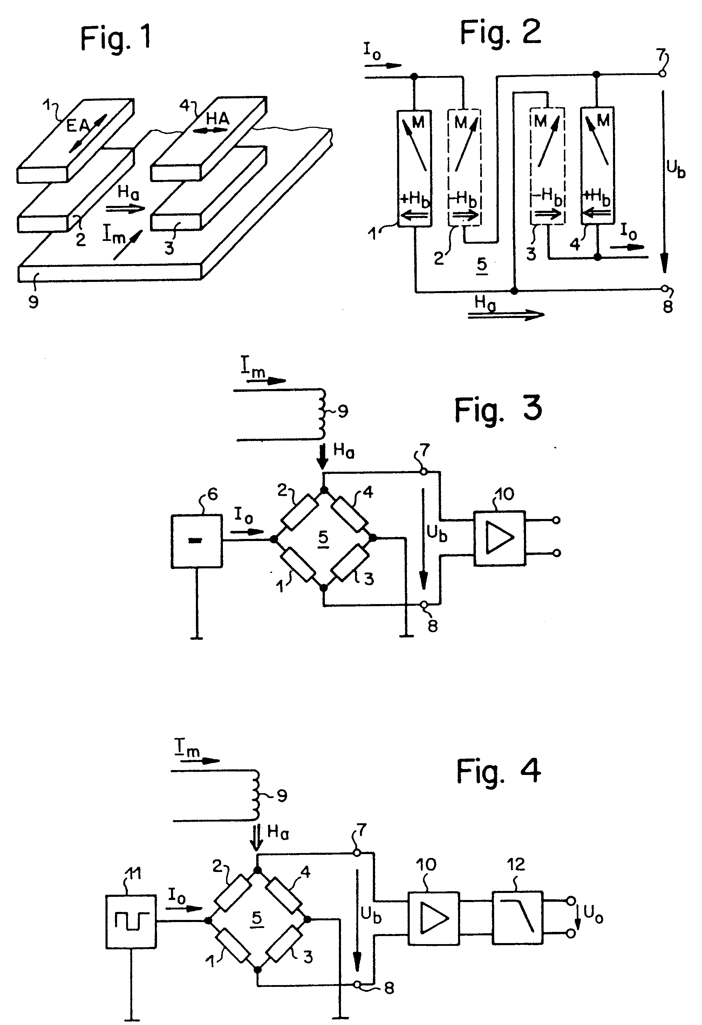

In der nicht massstäblich gezeichneten Figur 1 bedeuten 1 bis 4 vier Dünnfilme aus ferromagnetischem, magnetoresistivem Material. Die Dünnfilme 1 und 4 liegen in einer ersten gemeinsamen Ebene und die Dünnfilme 2 und 3 in einer zweiten, zur ersten Ebene parallelen Ebene. Der Dünnfilm 1 befindet sich deckungsgleich über dem Dünnfilm 2 und der Dünnfilm 4 deckungsgleich über dem Dünnfilm 3. Die Dünnfilme 1, 2 sowie die Dünnfilme 4, 3 sind gleich dick und bilden je ein Dünnfilmpaar, d.h. sie sind magnetisch miteinander gekoppelt und daher in sehr geringem Abstand durch eine nicht gezeichnete Schicht voneinander isoliert, übereinander angeordnet.

Wie aus der Figur 2 hervorgeht, bilden die Dünnfilme 1 bis 4 eine elektrische Brücke 5, bei der jedes der vier Brückenelemente aus einem einzigen Dünnfilm besteht, und somit die Dünnfilme 1, 2 bzw. 4, 3 eines Dünnfilmpaares jeweils verschiedenen Brückenelementen angehören.

Die Dünnfilme 2 und 3 sind in der Figur 2 gestrichelt gezeichnet, um anzudeuten, dass sie unter dem Dünnfilm 1 bzw. 4 liegen. Die beiden in der Zeichnung Figur 2 oben dargestellten Enden der links gezeigten Dünnfilme 1, 2 und die beiden in Figur 2 unten dargestellten Enden der rechts gezeigten Dünnfilme 3, 4, sind an eine Spannungs- oder Stromquelle 6 (Figur 3) angeschlossen, welche einen Strom $I_o$ in die Brücke 5 einspeist. Das eine Ende des Dünnfilms 2 sowie das andere Ende des Dünnfilms 4 sind mit einer Ausgangsklemme 7 und das eine Ende des Dünnfilms 1 sowie das andere Ende des Dünnfilms 3 mit einer Ausgangsklemme 8 der Brücke 5 verbunden.

Gemäss Figur 3 ist die Brücke 5 einem magnetischen Aussenfeld $H_a$ ausgesetzt. Dieses wird von einem Messstrom $I_m$ erzeugt, der in einem Leiter 9 in Richtung der leichten Magnetachse EA der Dünnfilme 1 bis 4 fliesst. Als Leiter 9 kann z.B. eine flache Leiterbahn oder eine Spule dienen, wobei die Brücke 5 in einer Zone anzuordnen ist, in welcher der Leiter 9 ein möglichst homogenes magnetisches Aussenfeld $H_a$ erzeugt, das die Dünnfilme 1 bis 4 in Richtung ihrer schweren Magnetachse HA magnetisiert.

Der im Dünnfilm 2 fliessende Strom $\frac{1}{2}I_o$ erzeugt im Dünnfilm 1 ein in der Zeichnung (Figur 2) nach links gerichtetes magnetisches Hilfsfeld $+ H_b$, wodurch der Magnetisierungsvektor M im Dünnfilm 1 im Gegenuhrzeigersinn um einen bestimmten Winkel aus der leichten Magnetachse EA herausgedreht wird. Analog entsteht durch den im Dünnfilm 3 fliessenden Strom $\frac{1}{2}I_o$ im Dünnfilm 4 ein Hilfsfeld $+ H_b$ und eine Drehung des Magnetisierungsvektors M im Gegenuhrzeigersinn. Der im Dünnfilm 1 bzw. 4 fliessende Strom $\frac{1}{2}I_o$ bewirkt im Dünnfilm 2 bzw. 3 ein nach rechts gerichtetes Hilfsfeld $-H_b$ und eine Drehung des Magnetisierungsvektors M im Uhrzeigersinn. Die daraus resultierende Widerstandsänderung ist in allen Dünnfilmen 1 bis 4 gleich, und die Brücke 5 bleibt im Gleichgewicht.

Sobald die Brücke 5 einem magnetischen Aussenfeld $H_a$ augesetzt wird, ändert sich der elektrische Widerstand in den verschieden vormagnetisierten Dünnfilmen 1 bis 4 unterschiedlich, und es entsteht eine Brückenspannung $U_b$, die ein lineares Abbild des Messstromes $I_m$ darstellt.

Innerhalb des zulässigen Aussteuerungsbereichs, der dadurch begrenzt ist, dass jeweils ein Dünnfilm der Dünnfilmpaare 1, 2 und 3, 4 gesättigt wird, gilt

$$U_b = \frac{2 \cdot \triangle R}{(1 + \gamma)^2 - \gamma_{12}^2} \cdot I_o \cdot h_b \cdot h_a \qquad (1)$$

Dabei bedeuten:
$\triangle R$ die maximale Widerstandsänderung der Dünnfilme,

$$\gamma = \frac{N \cdot M_s}{H_k} \text{ einen normierten Entmagnetisierungsfaktor,}$$

$$\gamma = \frac{N_{12} \cdot M_s}{H_k} \text{ einen normierten Kopplungsfaktor,}$$

N den Entmagnetisierungsfaktor in den Dünnfilmen,

$N_{12}$ die gegenseitige Beeinflussung der Dünnfilme eines Dünnfilmpaares,

$M_s$ die Sättigungsmagnetisierung,

$H_k$ die Anisotropiefeldstärke,

$$h_b = \frac{H_b}{H_k} \text{ und}$$

$$h_a = \frac{H_a}{H_k}$$

Es ist ersichtlich, dass die Stärke des Stromes $I_o$ und die vom Strom $I_o$ abhängige Stärke des Hilfsfeldes $H_b$ zwar konstant sein müssen, eine Justierung des Stromes $I_o$ jedoch nicht erforderlich ist, um eine lineare Abhängigkeit der Brückenspannung $U_b$ vom magnetischen Aussenfeld $H_a$ zu erzielen.

Gemäss der Figur 3 ist die Brücke 5 vorteilhafterweise an einen Differenzverstärker 10 angeschlossen, der einen konstanten Verstärkungsfaktor aufweist und die Brückenspannung $U_b$ auf ein zur Messung oder Anzeige geeignetes Mass verstärkt.

Zur Unterdrückung von Offsetspannungen der Brücke 5 ist diese in der Figur 4 aus einer Wechselspannungs- oder Wechselstromquelle 11 mit vorzugsweise rechteckförmigen Kurvenverlauf gespeist. Dem an die Ausgangsklemmen 7, 8 der Brücke 5 angeschlossenen Differenzverstärker 10 ist ein Filter 12 nachgeschaltet. Bei einem Vorzeichenwechsel des Stromes $I_o$ kehren auch die Hilfsfelder $H_b$ ihre Richtung um, so dass, wie aus Gleichung (1) ersichtlich ist, die Brückenspannung $U_b$ ihr Vorzeichen nicht wechselt. Am Ausgang des Filters 12 entsteht eine zum magnetischen Aussenfeld $H_a$ proportionale, von Offsetfehlern der Brücke 5 befreite Spannung $U_o$.

Vorteilhafterweise werden anstelle des Filters 12 zwei Filter eingesetzt, von denen das eine zwischen die Ausgangsklemme 7 und den ersten Eingang des Differenzverstärkers 10 und das andere zwischen die Ausgangsklemme 8 und den zweiten Eingang des Differenzverstärkers 10 geschaltet wird. Dies bringt den Vorteil mit sich, dass der Differenzverstärker 10 weder die sogenannte Common-Mode-Spannung der Brücke 5 noch durch Unsymmetrien der Brücke 5 verursachte steile Flanken der Brückenspannung $U_b$ verarbeiten muss und daher nicht breitbandig sein muss.

Die Wechselstromspeisung der Brücke 5 wird vorteilhafterweise dadurch realisiert, dass die Brücke 5 über einen Umpolschalter an eine Gleichstromquelle geschaltet wird. Dadurch ist auf einfache Weise gewährleistet, dass der Betrag des Stromes $I_o$ in beiden Flussrichtungen gleich gross ist.

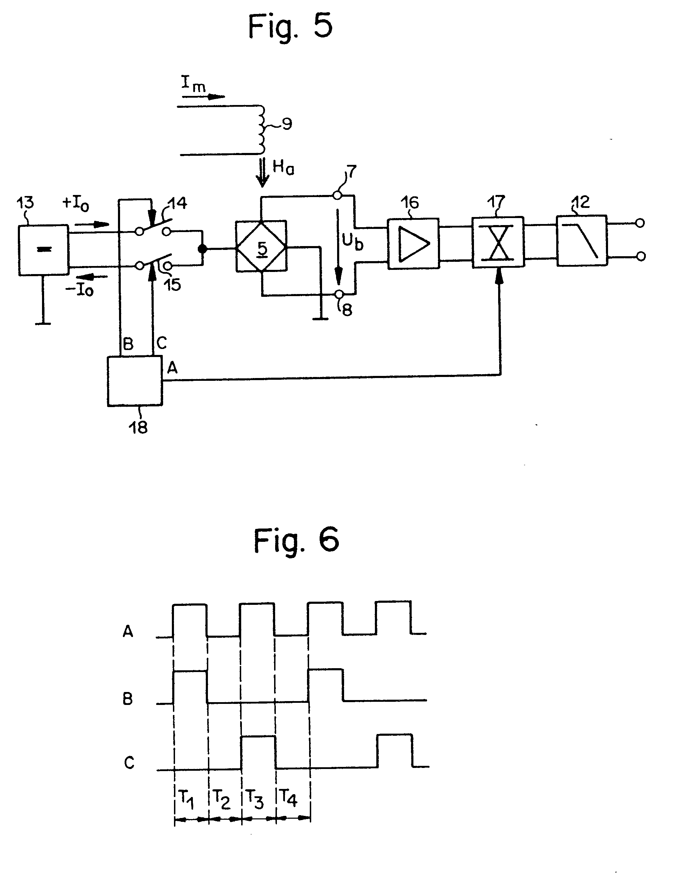

Anhand der Figur 5 wird gezeigt, wie auch Offsetfehler des der Brücke 5 nachgeschalteten Verstärkers eliminiert werden können. Eine Gleichstromquelle 13 speist die Brücke 5 über einen Schalter 14 mit einem positiven Strom $+I_o$ und über einen Schalter 15 mit einem negativen Strom $-I_o$. An die Ausgangsklemmen 7, 8 der Brücke 5 ist ein vorteilhafterweise als Wechselspannungsverstärker ausgebildeter Differenzverstärker 16 angeschlossen, welchem ein Synchrondetektor 17 und das Filter 12 nachgeschaltet sind. Eine Steuerschaltung 18 liefert zur Steuerung des Synchrondetektors 17 und der Schalter 14, 15 periodische Signale A, B und C (Figur 6).

Während eines ersten Zeitintervalls $T_1$ ist der Schalter 14 geschlossen und der Schalter 15 geöffnet. Die Brücke 5 wird mit dem Strom $+I_o$ gespeist und der Synchrondetektor 17 schaltet die verstärkte Brückenspannung $U_b$ sowie eine allfällige Offsetspannung des Differenzverstärkers 16 nichtinvertiert auf das Filter 12. Während eines zweiten Zeitintervalls $T_2$ sind beide Schalter 14, 15 geöffnet, so dass $U_b = 0$ ist; die Offsetspannung des Differenzverstärkers 16 wird vom Synchrondetektor 17 invertiert auf das Filter 12 geschaltet. Während eines dritten Zeitintervalls $T_3$ ist nur der Schalter 15 geschlossen und die verstärkte Brückenspannung $U_b$ sowie die Offsetspannung des Differenzverstärkers 16 werden nichtinvertiert auf das Filter 12 geschaltet. Während eines vierten Zeitintervalls $T_4$ sind wiederum beide Schalter 14, 15 geöffnet und die Offsetspannung des Differenzverstärkers 16 gelangt invertiert zum Filter 12.

Die Messung des Stromes $I_m$ erfolgt also jeweils während der Zeitintervalle $T_1$ und $T_3$. Die Offsetspannung des Differenzverstärkers 16 wird jeweils während der Zeitintervalle $T_1$ und $T_3$ nichtinvertiert und während der Zeitintervalle $T_2$ und $T_4$ invertiert auf das Filter 12 geschaltet. Da $T_1 = T_2 = T_3 = T_4$ ist, werden Offsetspannungen der Brücke 5 und des Differenzverstärkers 16 eliminiert.

Der beschriebene Stromdetektor besitzt lediglich vier Dünnfilme 1 bis 4, die auch zur Erzeugung der erforderlichen Hilfsfelder $H_b$ dienen, und zeichnet sich daher durch einen einfachen Aufbau aus. Er liefert bei galvanischer Trennung des Messtromes $I_m$, d.h. des Leiters 9, und der Ausgangsspannung $U_b$, d.h. der Brücke 5, ein lineares Abbild des Messtromes $I_m$. Er ist zur Messung von Wechsel- und Gleichströmen geeignet und als eisenkernloser Wandler in integrierter Schaltungstechnik herstellbar. Durch Parallelschaltung einer zusätzlichen Leiterbahn, die von der Brücke 5 genügend distanziert ist, kann für den Messtrom $I_m$ ein Stromteiler gebildet und dadurch der Messbereich des Stromdetektors in weiten Grenzen vorgewählt werden.

**Patentansprüche**

1. Magnetoresistiver Stromdetektor zur Bildung eines linearen Abbildes eines in einem elektrischen Leiter fliessenden Messstromes, mit einer aus einer Spannungs- oder Stromquelle (6, 11) gespeisten elektrischen Brücke (5), deren vier Brückenelemente ferromagnetische, magnetoresistive Dünnfilme (1, 2, 3, 4) aufweisen und die

dem vom Messstrom ($I_m$) erzeugten magnetischen Aussenfeld ($H_a$) so ausgesetzt ist, dass die Dünnfilme durch das magnetische Aussenfeld in Richtung ihrer schweren Magnetachse (HA) magnetisiert werden, wobei diejenigen Dünnfilme (1 bis 4), die in einer gemeinsamen Ebene angeordnet sind, gleich dick sind und jeweils zwei Dünnfilme (1; 2 bzw. 3; 4) zur Bildung eines Dünnfilmpaares (1, 2 bzw. 3, 4) deckungsgleich übereinander angeordnet und magnetisch so miteinander gekoppelt sind, dass der im einen Dünnfilm (1; 2 bzw. 3; 4) eines Dünnfilmpaares (1, 2 bzw. 3, 4) fliessende Strom ($I_o$) jeweils im anderen Dünnfilm (2; 1 bzw. 4; 3) des gleichen Dünnfilmpaares (1, 2 bzw. 3, 4) ein magnetisches Hilfsfeld ($+H_b$; $-H_b$) in Richtung der schweren Magnetachse (HA) erzeugt, dadurch gekennzeichnet, dass jedes Brückenelement aus einem einzigen Dünnfilm (1 bis 4) besteht und beide Dünnfilme (1; 2 bzw. 3; 4) jedes Dünnfilmpaares (1, 2 bzw. 3, 4) gleich dick ausgebildet und elektrisch voneinander isoliert sind.

2. Stromdetektor nach Anspruch 1, dadurch gekennzeichnet, dass die Brücke (5) an einen Differenzverstärker (10) angeschlossen ist.

3. Stromdetektor nach Anspruch 1, dadurch gekennzeichnet, dass die Brücke (5) mit einer Wechselspannung oder einem Wechselstrom gespeist und an einen Differenzverstärker (10) angeschlossen ist, welchem ein Filter (12) nachgeschaltet ist.

4. Stromdetektor nach Anspruch 1, dadurch gekennzeichnet, dass die Brücke (5) mit einer Wechselspannung oder einem Wechselstrom gespeist ist und dass eine erste Ausgangsklemme (7) der Brücke (5) über ein erstes Filter an einen ersten Eingang und eine zweite Ausgangsklemme (8) der Brücke (5) über ein zweites Filter an einen zweiten Eingang eines Differenzverstärkers (10) angeschlossen ist.

5. Stromdetektor nach Anspruch 1, dadurch gekennzeichnet, dass die Brücke (5) über einen ersten Schalter (14) mit einem positiven Strom ($+I_o$) und über einen zweiten Schalter (15) mit einem negativen Strom ($-I_o$) gespeist und an einen Differenzverstärker (16) angeschlossen ist, dem ein Synchrondetektor (17) und ein Filter (12) nachgeschaltet sind, und dass die Schalter (14; 15) und der Synchrondetektor (17) von einer Steuerschaltung (18) gesteuert sind.

**Claims**

1. A magnetoresistive current detector for forming a linear image of a current to be measured, which flows in an electrical conductor, comprising an electrical bridge (5) which is supplied from a voltage or current source (6, 11) and whose four bridge elements have ferromagnetic, magnetoresistive thin films (1, 2, 3, 4) and which is exposed to the magnetic external field ($H_a$) generated by the current ($I_m$), such that the thin films are magnetised by the magnetic external field in the direction of their hard magnetic axis (HA), wherein those thin films (1 to 4) which are disposed in a common plane are of equal thickness and two thin films (1; 2 and 3; 4) are respectively disposed in aligned relationship to form a respective thin film pair (1, 2 and 3, 4) and are magnetically coupled together in such a way that the current ($I_o$) flowing in one thin film (1; 2 and 3; 4) of a thin film pair (1, 2 and 3, 4) produces a magnetic auxiliary field ($+H_b$; $-H_b$) in the direction of the hard magnetic axis (HA) in the respective other thin film (2; 1 and 4; 3) of the same pair (1, 2 and 3, 4), characterised in that each bridge element comprises a single thin film (1 to 4) and both thin films (1; 2 and 3; 4) of each thin film pair (1, 2 and 3, 4) are equal in thickness and are electrically insulated from each other.

2. A current detector according to claim 1 characterised in that the bridge (5) is connected to a differential amplifier (10).

3. A current detector according to claim 1 characterised in that the bridge (5) is supplied with an a.c. voltage or an alternating current and is connected to a differential amplifier (10) having a filter (12) connected on its output side.

4. A current detector according to claim 1 characterised in that the bridge (5) is supplied with an a.c. voltage or an alternating current and that a first output terminal (7) of the bridge (5) is connected by way of a first filter to a first input of a differential amplifier (10) and a second output terminal (8) of the bridge (5) is connected by way of a second filter to a second input of the differential amplifier (10).

5. A current detector according to claim 1 characterised in that the bridge (5) is supplied with a positive current ($+I_o$) by way of a first switch (14) and with a negative current ($-I_o$) by way of a second switch (15) and is connected to a differential amplifier (16) having a synchronous detector (17) and a filter (12) on the output side thereof, and that the switches (14; 15) and the synchronous detector (17) are controlled by a control circuit (18).

**Revendications**

1. Détecteur de courant magnétorésistif pour la formation d'une représentation linéaire d'un courant de mesure s'écoulant dans un conducteur électrique avec, alimenté par une source de tension ou de courant (6, 11), un pont électrique (5) dont les quatre éléments de pont présentent des films minces magnétorésistifs et ferromagnétiques (1, 2, 3, 4) et qui sont exposés au champ magnétique extérieur ($H_a$) produit par le courant de mesure ($I_m$), de façon telle que les films minces sont aimantés par le champ magnétique extérieur dans le sens de leur axe magnétique fort (HA) où ceux des films minces (1 à 4) disposés dans un plan commun sont de même épaisseur, et où respectivement, pour former une paire de films minces (1, 2 ou respectivement 3, 4), deux films minces (1; 2 ou encore 3; 4) sont superposés en coïncidence et couplés mutuellement magnétiquement de façon que le courant

($I_o$) s'écoulant dans un film mince (1; 2 ou encore 3; 4) d'une paire de films minces (1, 2 ou respectivement 3, 4) produise respectivement, dans l'autre film mince (2; 1 ou encore 4; 3) de la même paire de films minces (1, 2 ou respectivement 3, 4), un champ magnétique auxiliaire ($+H_b$; $-H_b$) dans le sens de l'axe magnétique fort (HA) caractérisé en ce que chaque élément du pont consiste en un unique film mince (1 à 4) et en ce que les deux films minces (1; 2 ou encore 3; 4) de chaque paire de films minces (1, 2 ou respectivement 3, 4) ont la même épaisseur et sont mutuellement isolés électriquement.

2. Détecteur de courant selon la revendication 1, caractérisé en ce que le pont (5) est raccordé à un amplificateur différentiel (10).

3. Détecteur de courant selon la revendication 1, caractérisé en ce que le pont (5) est alimenté avec une tension alternative ou un courant alternatif et raccordé à un amplificateur différentiel (10), suivi en aval d'un filtre (12).

4. Détecteur de courant selon la revendication 1, caractérisé en ce que le pont (5) est alimenté avec une tension alternative ou un courant alternatif, et en ce qu'une première borne de sortie (7) du pont (5) est raccordée à travers un premier filtre à une première entrée, et une seconde borne de sortie (8) du pont (5) est raccordée à travers un second filtre à une seconde entrée d'un amplificateur différentiel (10).

5. Détecteur de courant selon la revendication 1, caractérisé en ce que le pont (5) est alimenté à travers un premier interrupteur (14) par un courant positif ($+I_o$) et alimenté à travers un second interrupteur (15) par un courant négatif ($-I_o$), et raccordé à un amplificateur différentiel (16) lequel est suivi en cascade d'un détecteur synchrone (17) et d'un filtre (12), et en ce que les interrupteurs (14; 15) et le détecteur synchrone (17) sont commandés par un circuit de commande (18).

# Fig. 1

# Fig. 2

# Fig. 3

# Fig. 4

# Fig. 5

# Fig. 6